# EUROPÄISCHE PATENTANMELDUNG

(11) **EP 4 495 298 A1**
(43) Veröffentlichungstag der Anmeldung: **22.01.2025**
(21) Anmeldenummer: 23186082.6
(22) Anmeldetag: 18.07.2023
(51) Int. Cl.: C30B 15/20, C30B 15/30, C30B 29/06, C30B 30/04

(54) **VERFAHREN ZUR HERSTELLUNG VON HALBLEITERSCHEIBEN AUS EINKRISTALLINEM SILIZIUM**

(71) Anmelder: Siltronic AG, 81677 München (DE)
(72) Erfinder: Mangelberger, Karl, 5122 Ach (AT); Arulanandu, Clement, 823676 Singapore (SG); Plate, Matiss, 84489 Burghausen (DE); Tan, Leon, 560232 Singapore (SG)
(74) Vertreter: Killinger, Andreas

(57) **Zusammenfassung**

Gegenstand der Erfindung ist ein Verfahren zur Herstellung von Halbleiterscheiben aus einkristallinem Silizium, umfassend das Ziehen eines zylindrischen Abschnitts und nachfolgend eines Endkonus eines Einkristalls aus Silizium aus einer Schmelze, die in einem Tiegel enthalten ist;
wobei die Ziehgeschwindigkeit beim Ziehen des Endkonus gegenüber der Ziehgeschwindigkeit beim Ziehen des zylindrischen Abschnittsendbereichs im Wesentlichen konstant bleibt;
das Drehen des Tiegels mit einer Drehgeschwindigkeit und in eine Drehrichtung während des Ziehens des zylindrischen Abschnitts und des Endkonus des Einkristalls; und
das Abtrennen der Halbleiterscheiben aus einkristallinem Silizium vom zylindrischen Abschnitt des Einkristalls, dadurch gekennzeichnet, dass die Ziehgeschwindigkeit während des Ziehens des Endkonus mindestens größer als 0,46 mm/min beträgt, dabei die Drehrichtung des Tiegels fortgesetzt gewechselt wird und eine Amplitude der Drehgeschwindigkeit vor und nach dem Wechsel der Drehrichtung nicht weniger als 6 U/min beträgt.

## Beschreibung

Gegenstand der Erfindung ist ein Verfahren zur Herstellung von Halbleiterscheiben aus einkristallinem Silizium.

Die Herstellung von Einkristallen aus Silicium erfolgt in den überwiegend praktizierten Fällen in einem Tiegelzieh-Verfahren (Czochralski-Verfahren oder CZ-Methode genannt) oder einem tiegelfreien Ziehverfahren (Zonenschmelz-Verfahren oder FZ-Methode genannt). Die stabförmigen Einkristalle mit Durchmessern von typischerweise 100 bis 300 mm dienen vornehmlich als Grundmaterial zur Herstellung von Scheiben ("wafer"), aus denen wiederum elektronische Bauelemente gefertigt werden.

Die Czochralski-Methode umfasst das Ziehen eines Einkristalls aus einer Schmelze, die in einem Tiegel enthalten ist. Der Einkristall wird an einem Keimkristall hängend aus der Schmelze gezogen. In der Regel wird zunächst ein Dünnhals (neck) am unteren Ende des Keimkristalls kristallisiert, damit Versetzungen zum Rand des Dünnhalses gelangen und auf diese Weise eliminiert werden. Das weitere Ziehen des Einkristalls aus Silizium wird in üblicher Weise fortgesetzt, und zwar mit dem Ziehen eines konusförmigen Abschnitts, eines zylindrischen Abschnitts und eines Endkonus des Einkristalls. Gegen Ende des Ziehvorgangs läuft der Einkristall konisch zu einem kleinen Durchmesser zusammen. Auf diese Weise wird vermieden, dass beim Trennen des Einkristalls von der Schmelze entstehende Gleitungen oder Versetzungen im Einkristall weit in den Einkristall, insbesondere in den zylindrischen Abschnitt, zurücklaufen. Vom zylindrischen Abschnitt des Einkristalls werden einkristalline Halbleiterscheiben aus Silizium abgeschnitten und weiterbearbeitet.

Besondere Bedeutung beim Ziehen eines Einkristalls aus Silizium gemäß der CZ-Methode hat die Kontrolle des Verhältnisses V/G von Ziehgeschwindigkeit V und axialem Temperaturgradienten G an der Kristallisationsgrenze.

Die Ziehgeschwindigkeit V ist die Geschwindigkeit, mit der der wachsende Einkristall von der Schmelze weg nach oben gehoben wird, und der axiale Temperaturgradient G ist ein Maß, das die Änderung der Temperatur an der Kristallisationsgrenze in Richtung des Kristallhubs anzeigt.

Liegt das Verhältnis V/G über einem kritischen Wert k1, so treten überwiegend Leerstellendefekte (vacancies) auf, die agglomerieren können und dann beispielsweise als COPs (crystal originated particles) identifiziert werden können. Sie werden je nach Nachweismethode auch als LPD (light point defects) oder LLS (localized light scatterer) bezeichnet.

Liegt das Verhältnis von V/G unter einem kritischen Wert k2, der kleiner als k1 ist, so treten überwiegend Eigenpunktdefekte in Form von Zwischengitteratomen (silicon self-interstitials) in Erscheinung, die ebenfalls Agglomerate bilden können und sich makroskopisch als Versetzungsschleifen zeigen. Agglomerate von Zwischengitteratomen formen lokale Kristallversetzungen aus, die aufgrund der angewendeten Nachweismethode auch als LPITs (large etch pits) bezeichnet werden.

Im weitesten Sinne wird der Bereich in dem weder eine Agglomeration von Leerstellen noch von Zwischengitteratomen stattfindet, in dem also V/G zwischen k1 und k2 liegt, als neutrale Zone oder perfekter Bereich bezeichnet. Der Wert von V/G bei dem der Kristall vom Leerstellen- zum Zwischengitterüberschuss wechselt liegt naturgemäß zwischen k1 und k2.

Der axiale Temperaturgradient G an der Kristallisationsgrenze und dessen radialer Verlauf werden bestimmt durch den Wärmetransport von und zur Kristallisationsgrenze. Der Wärmetransport wird wiederum wesentlich beeinflusst durch die thermischen Eigenschaften der Umgebung des wachsenden Einkristalls, der sogenannten hot zone, und durch die Wärmezufuhr durch eine oder mehrere Heizvorrichtungen.

Der axiale und radiale Verlauf des axialen Temperaturgradient G an der Kristallisationsgrenze kann mittels Simulationsrechnungen, die die Wärmebilanz berücksichtigen, bestimmt werden.

Um den Quotienten V/G auch in axialer Richtung in einem vorgesehenen Bereich zu halten, ist es erforderlich, die zeitliche Änderung des axialen Temperaturgradienten G durch eine entsprechende Änderung der Ziehgeschwindigkeit V zu kompensieren. Durch das Kontrollieren der Ziehgeschwindigkeit V kann also auch der Quotient V/G kontrolliert werden.

Sauerstoff spielt eine wichtige Rolle bei der Bildung von BMD-Defekten (BMDs, Bulk Micro Defects). BMDs sind Sauerstoffpräzipitate, die sich bei einer Wärmebehandlung aus BMD Nuklei bilden. BMDs wirken als interne Getter, d.h. als Energiesenken für Verunreinigungen und sind daher grundsätzlich vorteilhaft.

US 2020/199776 A1 offenbart ein Verfahren zur Herstellung eines Silicium-Einkristalls, bei dem - falls während des Kristallziehens Versetzungen auftreten - mit der gleichen Ziehgeschwindigkeit weitergezogen wird, bis der Startpunkt der Versetzungen durch eine Temperaturzone tritt, bei der sich BMD Nuklei bilden. Das Verfahren zielt also darauf, die thermische Geschichte im nichtversetzten Bereich nicht durch Änderungen des Ziehprozesses zu beeinflussen und bei späteren thermischen Behandlungen dieser Scheiben die Bildung von BMDs zu ermöglichen.

EP4025726A1 offenbart ein Verfahren zur Herstellung von Halbleiterscheiben aus einkristallinem Silizium mittels CZ, bei dem die Drehrichtung des Tiegels fortgesetzt gewechselt wird. Dadurch lassen sich axiale Schwankungen der Konzentration von Sauerstoff im zylindrischen Abschnitt des Einkristalls, ausgedrückt als Differenz von größter Konzentration und kleinster Konzentration, mehr als halbieren.

Bei der Untersuchung von aus dem zylindrischen Abschnitt eines Einkristalls im Bereich von 75% bis 95% der Stablänge abgetrennten Scheiben hat sich eine Erhöhung von LLS mit einer Größe von kleiner als 19 nm gezeigt. LLS dieser Größe lassen sich mit dem Partikelmessgerät SP5 von KLA Corp. mittels Streulichtmessung detektieren.

Die Aufgabe der Erfindung bestand darin, die LLS-Belastung der Scheiben zu reduzieren.

Die Aufgabe der Erfindung wird gelöst durch ein Verfahren zur Herstellung von Halbleiterscheiben aus einkristallinem Silizium, umfassend das Ziehen eines zylindrischen Abschnitts und nachfolgend eines Endkonus eines Einkristalls aus Silizium aus einer Schmelze, die in einem Tiegel enthalten ist;
wobei die Ziehgeschwindigkeit beim Ziehen des Endkonus gegenüber der Ziehgeschwindigkeit beim Ziehen des zylindrischen Abschnitts im Wesentlichen konstant bleibt;
das Drehen des Tiegels mit einer Drehgeschwindigkeit und in eine Drehrichtung während des Ziehens des zylindrischen Abschnitts und des Endkonus des Einkristalls; und
das Abtrennen der Halbleiterscheiben aus einkristallinem Silizium vom zylindrischen Abschnitt des Einkristalls, dadurch gekennzeichnet, dass die Ziehgeschwindigkeit während des Ziehens des Endkonus mindestens größer 0,46 mm/min beträgt, dabei die Drehrichtung des Tiegels fortgesetzt gewechselt wird und eine Amplitude der Drehgeschwindigkeit vor und nach dem Wechsel der Drehrichtung nicht weniger als 6 U/min beträgt.

Durch das erfindungsgemäße Verfahren lassen sich LLS mit einer Größe von kleiner als 19 nm an vom zylindrischen Abschnitt des Einkristalls im Bereich von 75% bis 95% der Stablänge abgetrennten Scheiben deutlich reduzieren.

Dies hängt nach Ansicht der Erfinder damit zusammen, dass durch das Verfahren die Verweilzeit in diesem Abschnitt (75% bis 95% der Stablänge) verringert wird. Dies wird später in den Beispielen gezeigt.

Bevorzugte Ausführungsformen der Erfindung werden in der nachfolgenden Beschreibung und in den Ansprüchen dargestellt.

Vorzugsweise wird die Schmelze, zumindest während des Ziehens des zylindrischen Abschnitts des Einkristalls, mit einem horizontalen Magnetfeld beaufschlagt. Das horizontale Magnetfeld hat im Bereich der Phasengrenze zwischen dem wachsenden Einkristall und der Schmelze eine Intensität von vorzugsweise nicht weniger als 0,2 T und nicht mehr 0,4 T.

Das erfindungsgemä0e Verfahren eignet sich besonders zur Herstellung von einkristallinen Halbleiterscheiben aus Silizium mit einem Durchmesser von mindestens 200 mm, insbesondere mit einem Durchmesser von mindestens 300 mm.

Beim Wachsen des zylindrischen Abschnitts des Kristalls wird v/G vorzugsweise so eingestellt, dass der Stab frei von Agglomeraten von Leerstellen und Zwischengitteratomen ist, die daraus hergestellten Scheiben also keine L-Pits und COPs enthalten.

In einer Ausführungsform treten beim Ziehen des zylindrischen Abschnitts des Einkristalls keine Versetzungen auf.

Die Tiegelwechseldrehung bei der Erzeugung des Endkonus führt zu einer stabileren Form des Endkonus. Die Versetzungshäufigkeit des Endkonus konnte um 2% reduziert werden.

Die bezüglich der vorstehend aufgeführten Ausführungsformen des erfindungsgemäßen Verfahrens angegebenen Merkmale können entweder separat oder in Kombination als Ausführungsformen der Erfindung verwirklicht werden. Weiterhin können sie vorteilhafte Ausführungen beschreiben, die selbstständig schutzfähig sind.

### Beispiele

Die Simulation der thermischen Geschichte des CZ-Prozesses zeigt eine hohe Verweilzeit im Temperaturbereich zwischen 600°C bis 700°C in dem Stabbereich (75-95%), in dem auch die LLS Defekte beobachtet wurden.

Durch eine Erhöhung der Ziehgeschwindigkeit im Endkonus und einer hohen Tiegelwechseldrehung kann die Verweilzeit so verringert werden, dass die Defekte deutlich reduziert werden.

Es wurden verschiedene Ziehgeschwindigkeiten simuliert und experimentell getestet.

### Vergleichbeispiel:

niedrigere Ziehgeschwindigkeit Endkonus (-10%)

### Beispiel 1:

Niedrigere Ziehgeschwindigkeit Stabende, dann konstant von Stabende zu Endkonus

### Beispiel 2:

Höhere Ziehgeschwindigkeit Stabende zu Endkonus

### (/Erfindungsgemäßes) Beispiel 3:

Höhere Ziehgeschwindigkeit Stabende zu Endkonus und Tiegelwechseldrehung Endkonus

**Tabelle 1** zeigt die minimalen und maximalen Verweilzeiten für **Vergleichsbeispiel** und **Beispiele 1** bis **3,** ermittelt durch numerische Simulationen.

**Tabelle 1**

| | Minimale Verweilzeit / min | Maximale Verweilzeit / min | Verhältnis |
|---|---|---|---|
| Vergleichsbeispiel | 241 | 558 | 2.3 |
| Beispiel 1 | 241 | 496 | 2.1 |
| Beispiel 2 | 241 | 502 | 2.1 |
| Beispiel 3 | 241 | 459 | 1.9 |

**Beispiele 1** bis **3** führen zu einer deutlichen Reduktion von LLS < 19 nm, wie **Tabelle 2** zeigt.

**Tabelle 2**

| | LPD counts / wafer < 19 nm | COPs / LPits |
|---|---|---|
| Vergleichsbeispiel | 71.8 | keine |
| Beispiel 1 | 19.2 | keine |
| Beispiel 2 | 18.1 | COPs am Stabende |
| Beispiel 3 | 11.3 | keine |

Allerdings zeigen sich im **Beispiel 2** (ohne Tiegelwechseldrehung) COPs am Stabende.

Nur **Beispiel 3** mit erhöhter Ziehgeschwindigkeit und Tiegelwechseldrehung führt zu einer noch deutlicheren Reduktion von LLS (gegenüber den **Beispielen 1** und **2**) und gleichzeitigem Vermeiden von COPs.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Verfahren zur Herstellung von Halbleiterscheiben aus einkristallinem Silizium, umfassend das Ziehen eines zylindrischen Abschnitts und nachfolgend eines Endkonus eines Einkristalls aus Silizium aus einer Schmelze, die in einem Tiegel enthalten ist;
wobei die Ziehgeschwindigkeit beim Ziehen des Endkonus gegenüber der Ziehgeschwindigkeit beim Ziehen des zylindrischen Abschnittsendbereichs im Wesentlichen konstant bleibt;
das Drehen des Tiegels mit einer Drehgeschwindigkeit und in eine Drehrichtung während des Ziehens des zylindrischen Abschnitts und des Endkonus des Einkristalls; und
das Abtrennen der Halbleiterscheiben aus einkristallinem Silizium vom zylindrischen Abschnitt des Einkristalls, **dadurch gekennzeichnet, dass** die Ziehgeschwindigkeit während des Ziehens des Endkonus mindestens größer als 0,46 mm/min beträgt, dabei die Drehrichtung des Tiegels fortgesetzt gewechselt wird und eine Amplitude der Drehgeschwindigkeit vor und nach dem Wechsel der Drehrichtung nicht weniger als 6 U/min beträgt.

2. Verfahren nach Anspruch 1, wobei die Ziehgeschwindigkeit während des Ziehens des Endkonus mindestens größer 0,5 mm/min beträgt.

3. Verfahren nach einem der Ansprüche 1 bis 2, wobei die Verweildauer eines Bereichs von 75% bis 95% der Stablänge des zylindrischen Abschnitts im Temperaturbereich von 600-700°C weniger als 460 min beträgt.

4. Verfahren nach einem der Ansprüche 1 bis 3, wobei die abgetrennten Halbleiterscheiben frei von COPs und LPits sind.

5. Verfahren nach einem der Ansprüche 1 bis 4, wobei beim Ziehen des zylindrischen Abschnitts des Einkristalls keine Versetzungen auftreten.

6. Verfahren nach einem der Ansprüche 1 bis 5, wobei die Schmelze mit einem horizontalen Magnetfeld beaufschlagt wird.
